# EUROPEAN PATENT SPECIFICATION

(11) **EP 1 668 712 B1**
(45) Date of publication and mention of the grant of the patent: **10.01.2007**
(21) Application number: 04769346.0
(22) Date of filing: 10.09.2004
(51) Int. Cl.: H01L 39/14, H01L 39/24

(54) **SUPERCONDUCTIVE COMPOSITE TAPE AND CORRESPONDING METHOD OF FABRICATION**
SUPRALEITENDES KOMPOSITBAND UND ENTSPRECHENDES HERSTELLUNGSVERFAHREN
BANDE COMPOSITE SUPRACONDUCTRICE ET SON PROCEDE DE FABRICATION

(30) Priority: 11.09.2003 IT TO20030692
(43) Date of publication of application: 14.06.2006
(73) Proprietor: EDISON S.p.A., 20120 Milano (IT)
(72) Inventor: BALDINI, Alberto, I-50137 Firenze (IT); SBRANA, Armando, I-55100 Lucca (IT); SERRACANE, Claudio, I-20035 Lissone (IT); ZANNELLA, Sergio, I-22066 Mariano Comense (IT)
(74) Representative: Jorio, Paolo
(86) International application number: PCT/IB2004/002954
(87) International publication number: WO 2005/024963

(56) References cited:
- WO-A-01/08169
- WO-A-01/18885
- DE-A- 4 004 908
- DE-U1- 9 111 328
- OBERLY C E ET AL: "The importance of interfilamentary barrier resistance in YBCO coated conductor to minimize ac losses" INTERNATIONAL CRYOGENIC MATERIALS CONFERENCE, MADISON, WI, USA, 16-20 JULY 2001, no. 614B, 2002, pages 621-630, XP002311092 AIP CONFERENCE PROCEEDINGS ISSN: 0094-243X

## Description

### TECHNICAL FIELD

The present invention relates to a superconductive composite tape and to a method of fabrication thereof.

### BACKGROUND ART

Superconductive composite tapes (so-called "coated conductors") are of considerable industrial interest. In general terms, superconductive composite tapes are formed by a flexible metal substrate, one or more intermediate barrier or buffer layers, and a layer made of superconductive material, for example RE-Ba₂Cu₃O_{7-d} (REBCO) or YBa₂Cu₃O_{7-d} (YBCO).

Currently available superconductive composite tapes are not, however, fully satisfactory in terms of electrical and thermal stabilization and moreover present a relatively high dissipation of energy in the presence of currents and/or magnetic fields that vary in time. These drawbacks are particularly important for applications in the energy sector.

The document DE 40 04 908 A1 shows a composite superconductor tape wherein YBCO layer strips formed on a metal substrate are embedded in and covered by a metallic coating such as silver.

The article "The importance of interfilamentary barrier resistance in YBCO coated conductor to minimize AC losses" by C.E. Oberly et al, International Cryogenics Materials Conference, AIP Conference Proceedings No. 614B, 2002, pages 621-630 (XP2311092) discloses a similar multifilamentary composite YBCO coated conductor tape with resistive material like silver or dielectrics filled into the interfilament grooves.

### DISCLOSURE OIF INVENTION

A purpose of the present invention is consequently to provide a superconductive composite tape and a corresponding method of fabrication that will enable the drawbacks of the known art referred to above to be overcome.

A particular purpose of the invention is to provide a superconductive composite tape having good characteristics of electrical and thermal stabilization and low energy dissipation in the presence of currents and/or magnetic fields that vary in time.

A further purpose of the invention is to provide a method for obtaining said superconductive composite tape in a relatively simple, fast, and economically advantageous way.

In accordance with said purposes, the present invention relates to a superconductive composite tape and to a method of fabrication thereof, as defined in the annexed Claim 1 and Claim 12, respectively.

According to the invention, there is hence provided a superconductive composite tape, in which the layer made of superconductive material is divided into thin superconductive filaments, separated from one another. Splitting of the superconductive material into thin filaments enables both an electrical and thermal stabilization and the reduction in energy dissipation in the presence of currents and/or magnetic fields that vary in time.

The superconductive composite tape with multifilament structure according to the invention is hence suited to a particularly advantageous application in the energy sector.

### BRIEF DESCRIPTION OF THE DRAWINGS

Further characteristics and advantages of the present invention will emerge clearly from the description of the following non-limiting examples of embodiment, with reference to the figures of the annexed of drawings, in which:
- Figure 1 is a schematic illustration of a step of the method of fabrication of a superconductive composite tape according to the invention;
- Figures 2 and 3 are schematic cross-sectional views of a superconductive composite tape in two subsequent steps of the method of fabrication according to the invention; and
- Figure 4 illustrates a preferred embodiment of the superconductive composite tape made according to the invention.

### BEST MODE FOR CARRYING OUT THE INVENTION

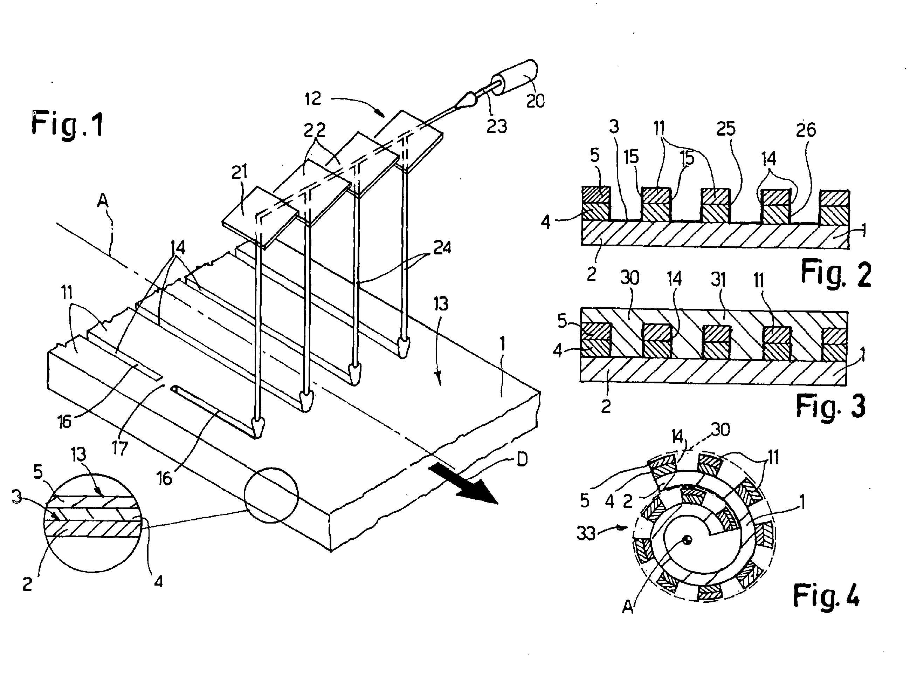

In Figure 1, designated by 1 is a superconductive composite tape, comprising a substrate 2, in particular a ribbon-shaped flexible metal substrate (for example, an alloy of Ni, Cu, etc.), on a surface 3 of which there are deposited at least one intermediate buffer layer 4, made, for example, of metal oxide, and a layer 5 made of superconductive material, for example REBCO or YBCO.

The substrate 2 is provided with the buffer layer 4 and the layer 5 via known techniques of deposition.

The method according to the invention envisages then the formation in the layer 5 of a plurality of superconductive filaments 11, substantially parallel to one another and to a longitudinal axis A of the tape and laterally at a distance from one another.

In particular, the filaments 11 are formed in an etching step, schematically illustrated in Figure 1. The tape 1 is fed continuously, in a direction of advance D parallel to the axis A, to a micro-etching apparatus 12, for example an apparatus for laser etching, set above a face 13 of the tape 1 defined by an outer surface of the layer 5. The apparatus 12 digs a plurality of grooves 14 through the layer 5 throughout the thickness of the layer 5 so as to delimit the filaments 11. Each filament 11 has a pair of side walls 15.

The grooves 14 can be continuous, i.e., extending substantially throughout the length of the tape 1, or else be constituted by discontinuous stretches 16, in such a way that each groove 14 is interrupted by a series of transverse bridges 17 made of superconductive material (only one of which is shown in Figure 1 for reasons of simplicity) set for connection of adjacent filaments 11. The presence of the bridges 17 has positive effects in terms of electrical stabilization and reduces the leakages due to the coupling of the filaments 11.

In any case, as illustrated in detail in Figure 2, the tape 1 is etched until the substrate 2 is reached and, hence, until the surface 3 is exposed. The grooves 14 are formed through the layer 5 and the buffer layer 4 and possibly penetrate slightly into the substrate 2 underneath the surface 3.

In the example illustrated in Figure 1, the apparatus 12 comprises a laser source 20, operating in the visible and/or in the ultraviolet, and an optical assembly 21 that intercepts the beam 23 emitted by the source 20 and splits it, for example, via appropriately oriented plates 22, into a plurality of parallel beams 24 substantially orthogonal to the face 13, each of which etches a groove 14, removing the material with which it interacts.

The diameter, power, duration, and wavelength of the beams 23, 24 are selected so as to obtain grooves 14 of the required dimensions. For example, the grooves have a width of approximately 10 - 50 µm and a depth of 0.1 - 3 µm (and in any case such as to expose the substrate 2).

The bridges 17, if they are envisaged, are advantageously obtained, interrupting etching of the grooves at pre-set intervals during advance of the tape 1.

It remains understood that the grooves 14 can be etched with techniques other than laser etching, using micro-machining equipment of any known type.

The method according to the invention comprises also a step of providing the side walls 15 of the filaments 11 with resistive barriers 25.

In the case in point, the resistive barriers 25 are defined by respective portions 26 of a small thickness of the side walls 15. The portions 26 extend along the filaments 11 and within each filament 11. In each portion 26, the superconductive material has a structure modified with respect to the body of the layer 5 (i.e., of the filaments 11), and hence defines a resistive barrier 25.

In this case, the resistive barriers 25 are advantageously obtained in the etching step by modifying the structure of the superconductive material of the side walls 15. In general, the characteristics of the beam 23 and the process parameters of the etching step are selected in such a way as to prevent any excessive heating of the area surrounding the etches produced by the beams 24 in order to prevent excessive degradation of the materials of the layer 5, of the buffer layer 4, and of the substrate 2. However, a limited thermal degradation of said materials, and specifically of the superconductive material, in the strict proximity of the side walls 15 and in an area limited to the portions 26 brings about the desired formation of the resistive barriers 25.

Thanks to the presence of the resistive barriers 25, the filaments 11 are electromagnetically uncoupled from one another.

According to an embodiment of the invention, schematically illustrated in Figure 3, the method according to the invention then comprises a coating step, in which the filaments 11 are embedded in a coating material, in particular a metal material that is highly conductive both from the electrical standpoint and from the thermal standpoint (for example, Cu, Ag, Au, etc.), which forms a coating 30 of a thickness of a few micron on the tape 1.

In the coating step, the coating material is introduced into the grooves 14 and fills the grooves 14 completely, and is moreover deposited on the face 13 to coat the filaments 11.

Each individual filament 11 is consequently embedded in a metal matrix 31, each filament 11 being surrounded on three sides by the coating material, which, in turn, is in direct contact with the underlying metal substrate 2.

In this way, a highly stabilized structure is obtained.

A preferred embodiment, schematically illustrated in Figure 4, then envisages that the tape 1, already provided with the grooves 14 delimiting the filaments 11 and with the coating 30 (represented by a dashed line in Figure 4), is sent on to a winding step, in which the tape 1 is wound on itself about the axis A in a transverse direction so as to form a superconductive thread 33 with a multifilament structure, in which the filaments 11 are substantially parallel to one another and to the axis A.

Alternatively, a step of twisting of the tape 1 on itself along the axis A is envisaged so as to form a tress-like thread 33, in which the filaments 11 are substantially spirally wound with respect to one another.

Preferably, the tape 1 is first of all wound on itself about the axis A to form a thread 33 with parallel filaments 11, and subsequently the thread 33 is in turn twisted on itself to form a tress along the axis A. There is in this way achieved an advantageous effect of reduction of the leakages.

## Claims

1. A superconductive composite tape (1), comprising a substrate (2) and a layer (5) made of superconductive material, said superconductive material layer (5) comprising a plurality of superconductive filaments (11) , which are substantially parallel to one another and to a longitudinal axis (A) of the tape and are spaced out from one another; the tape being **characterized in that** it comprises a coating (30) made of a conductive coating material, the filaments (11) being embedded in the coating (30); and **in that** each filament (11) is delimited by a pair of side walls (15) provided with resistive barriers (25).

2. The tape according to Claim 1, **characterized in that** the resistive barriers (25) are defined by respective portions (26) of the side walls (15) in which the superconductive material has a structure modified with respect to the body of the superconductive material layer (5).

3. The tape according to Claim 1 or 2, **characterized in that** the filaments (11) are separated from one another by grooves (14) formed through said superconductive material layer (5) throughout the whole thickness of said superconductive material layer (5).

4. The tape according to Claim 3, **characterized in that** the grooves (14) are interrupted by transverse bridges (17) for connection between adjacent filaments (11).

5. The tape according to Claim 3 or Claim 4, **characterized in that** the grooves (14) extend in depth up to the substrate (2).

6. The tape according to any one of Claims 3 to 5, **characterized in that** it comprises at least one buffer layer (4), interposed between the substrate (2) and the superconductive material layer (5), the grooves (14) extending through the superconductive material layer (5) and through the buffer layer (4) up to the substrate (2).

7. The tape according to any one of the preceding Claims, **characterized in that** the coating material is a metal material.

8. The tape according to any one of the preceding Claims, **characterized in that** the coating (30) fills the grooves (14) and coats the filaments (11).

9. The tape according to any one of the preceding Claims, **characterized in that** it is wound on itself around said axis (A) to form a thread (33) in which said filaments (11) are substantially parallel to said axis (A).

10. The tape according to any one of the preceding Claims, **characterized in that** it is twisted on itself along said axis (A) to form a tress-like thread (33), in which the filaments (11) are substantially spirally wound with respect to one another.

11. The tape according to any one of the preceding Claims, **characterized in that** the filaments (11) are connected to one another by transverse bridges (17) made of superconductive material.

12. A method of fabrication of superconductive composite tapes, comprising a step of providing a superconductive composite tape (1) having a superconductive material layer (5) positioned on a substrate (2), and a step of forming in the superconductive material layer (5) a plurality of superconductive filaments (11) delimited by respective pair of side walls (15), the filaments (15) being substantially parallel to one another and to a longitudinal axis (A) of the tape and being spaced out from one another; the method being **characterized by** further comprising a step of providing the side walls (15) of the filaments (11) with resistive barriers (25), and a coating step, in which the filaments (11) are embedded in a conductive coating material that forms a coating (30) of the tape (1).

13. The method according to Claim 12, **characterized by** comprising an etching step, in which a plurality of grooves (14) is dug through the superconductive material layer (5) throughout the whole thickness of said superconductive material layer (5) in order to delimit the filaments (11); said resistive barriers (25) being formed in said etching step, by modifying the structure of the superconductive material of said side walls (15).

14. The method according to Claim 13, **characterized in that**, in the etching step, the grooves (14) are dug in discontinuous stretches, in such a way that each groove (14) is interrupted by transverse bridges (17) connecting adjacent filaments.

15. The method according to Claim 13 or Claim 14, **characterized in that**, in the etching step, the tape (1) is dug up to the substrate (2).

16. The method according to any one of Claims 13 to 15, **characterized in that** the tape (1) comprises at least one buffer layer (4) set between the substrate (2) and the superconductive material layer (5), and the etching step is carried out through the superconductive material layer (5) and through the buffer layer (4) up to the substrate (2).

17. The method according to any one of Claims 12 to 16, **characterized in that** the coating material is a metal material.

18. The method according to any one of Claims 12 to 17, **characterized in that**, in said coating step, the coating material fills said grooves (14) and coats said filaments (11).

19. The method according to any one of Claims 12 to 18, **characterized in that** it comprises a step of winding the tape (1) on itself about said axis (A) to form a thread (33) in which the filaments (11) are substantially parallel to said axis (A).

20. The method according to any one of Claims 12 to 19, **characterized in that** it comprises a step of twisting the tape (1) on itself along said axis (A) to form a tress-like thread (33) in which said filaments (11) are substantially spirally wound with respect to one another.

21. The method according to any one of Claims 12 to 20, **characterized in that** it comprises a step of connecting the filaments (11) to one another via transverse bridges (17) made of superconductive material.

## Patentansprüche

1. Supraleitendes Kompositband (1) mit einem Substrat (2) und einer Schicht (5) aus supraleitendem Material, wobei die Schicht (5) aus supraleitendem Material mehrere supraleitende Filamente (11) aufweist, die zueinander und zu einer Längsachse (A) des Bandes im wesentlichen parallel sind und voneinander beabstandet sind, wobei das Band **dadurch gekennzeichnet ist, dass** es eine Beschichtung (30) aus einem leitfähigen Beschichtungsmaterial aufweist, wobei die Filamente (11) in der Beschichtung (30) eingebettet sind, und dass jedes Filament (11) durch zwei Seitenwände (15) begrenzt ist, welche mit Widerstandssperrschichten (25) versehen sind.

2. Band nach Anspruch 1, **dadurch gekennzeichnet, dass** die Widerstandssperrschichten (25) durch jeweilige Bereiche (26) der Seitenwände (15) gebildet sind, in welchen das supraleitende Material eine Struktur hat, welche in bezug auf den Körper der supraleitenden Materialschicht (5) modifiziert ist.

3. Band nach Anspruch 1 oder 2, **dadurch gekennzeichnet, dass** die Filamente (11) voneinander durch Nuten (14) getrennt sind, die über die gesamte Dicke der supraleitenden Materialschicht (5) durch die supraleitende Materialschicht (5) hindurch gebildet sind.

4. Band nach Anspruch 3, **dadurch gekennzeichnet, dass** die Nuten (14) durch querverlaufende Brücken (17) zum Verbinden benachbarter Filamente (11) unterbrochen sind.

5. Band nach Anspruch 3 oder Anspruch 4, **dadurch gekennzeichnet, dass** sich die Nuten (14) in ihrer Tiefe bis zu dem Substrat (2) erstrecken.

6. Band nach einem der Ansprüche 3 bis 5, **dadurch gekennzeichnet, dass** es mindestens eine Pufferschicht (4) aufweist, die zwischen dem Substrat (2) und der supraleitenden Materialschicht (5) angeordnet ist, wobei die Nuten (14) sich durch die supraleitende Materialschicht (5) und durch die Pufferschicht (4) bis zum Substrat (2) erstrecken.

7. Band nach einem der vorhergehenden Ansprüche, **dadurch gekennzeichnet, dass** das Beschichtungsmaterial ein Metallmaterial ist.

8. Band nach einem der vorhergehenden Ansprüche, **dadurch gekennzeichnet, dass** die Beschichtung (30) die Nuten (14) füllt und die Filamente (11) beschichtet.

9. Band nach einem der vorhergehenden Ansprüche, **dadurch gekennzeichnet, dass** es zur Bildung eines Stranges (33) um die Achse (A) auf sich selbst gewickelt ist, bei dem die Filamente (11) im wesentlichen parallel zu der Achse (A) verlaufen.

10. Band nach einem der vorhergehenden Ansprüche, **dadurch gekennzeichnet, dass** es zur Bildung eines verdrillten Stranges (33) entlang der Achse (A) auf sich selbst gedreht ist, bei dem die Filamente (11) in bezug zueinander im wesentlichen spiralig gewunden sind.

11. Band nach einem der vorhergehenden Ansprüche, **dadurch gekennzeichnet, dass** die Filamente (11) miteinander durch quer verlaufende Brücken (17) aus supraleitendem Material verbunden sind.

12. Verfahren zur Herstellung von supraleitenden Kompositbändern, mit dem Schritt des Vorsehens eines supraleitenden Kompositbandes (1) mit einer auf einem Substrat (2) angeordneten supraleitenden Materialschicht (5) und dem Schritt des Bildens mehrerer supraleitender Filamente (11) in der supraleitenden Materialschicht (5), welche durch jeweils zwei Seitenwände (15) begrenzt sind, wobei die Filamente (11) im wesentlichen parallel zueinander und zu einer Längsachse (A) des Bandes verlaufen und voneinander beabstandet sind, wobei das Verfahren ferner **dadurch gekennzeichnet ist, dass** es einen Schritt des Vorsehens der Seitenwände (15) der Filamente (11) mit Widerstandssperrschichten (25) und einen Beschichtungsschritt umfasst, in dem die Filamente (11) in ein leitfähiges Beschichtungsmaterial eingebettet werden, das eine Beschichtung (30) des Bandes (1) bildet.

13. Verfahren nach Anspruch 12, **gekennzeichnet durch** einen Ätzschritt, bei dem mehrere Nuten (14) **durch** die supraleitende Materialschicht (5) über die gesamte Dicke der supraleitenden Materialschicht (5) ausgebildet werden, um die Filamente (11) zu begrenzen; wobei die Widerstandssperrschichten (25) in dem Ätzschritt **durch** Modifizieren der Struktur des supraleitenden Materials der Wände (15) gebildet werden.

14. Verfahren nach Anspruch 13, **dadurch gekennzeichnet, dass** in dem Ätzschritt die Nuten (14) in unterbrochenen Erstreckungen derart ausgebildet werden, dass jede Nut (14) durch quer verlaufende Brücken (17) unterbrochen ist, die benachbarte Filamente verbinden.

15. Verfahren nach Anspruch 13 oder Anspruch 14, **dadurch gekennzeichnet, dass** in dem Ätzschritt das Band (1) bis zu dem Substrat (2) ausgenommen wird.

16. Verfahren nach einem der Ansprüche 13 bis 15, **dadurch gekennzeichnet, dass** das Band (1) wenigstens eine Pufferschicht (4) aufweist, die sich zwischen dem Substrat (2) und der supraleitenden Materialschicht (5) befindet, und der Ätzschritt durch die supraleitende Materialschicht (5) und durch die Pufferschicht (4) hindurch bis zum Substrat (2) durchgeführt wird.

17. Verfahren nach einem der Ansprüche 12 bis 16, **dadurch gekennzeichnet, dass** das Beschichtungsmaterial ein Metallmaterial ist.

18. Verfahren nach einem der Ansprüche 12 bis 17, **dadurch gekennzeichnet, dass** in dem Beschichtungsschritt das Beschichtungsmaterial die Nuten (14) füllt und die Filamente (11) beschichtet.

19. Verfahren nach einem der Ansprüche 12 bis 18, **dadurch gekennzeichnet, dass** es einen Schritt des Wickelns des Bandes (1) um die Achse (A) auf sich selbst zur Bildung eines Stranges (33) aufweist, bei dem die Filamente (11) im wesentlichen parallel zu der Achse (A) verlaufen.

20. Verfahren nach einem der Ansprüche 12 bis 19, **dadurch gekennzeichnet, dass** es einen Schritt des Drehens des Bandes (1) um sich selbst entlang der Achse (A) zur Bildung eines verdrillten Stranges (33) umfasst, bei dem die Filamente (11) in bezug zueinander im wesentlichen spiralig gewunden sind.

21. Verfahren nach einem der Ansprüche 12 bis 20, **dadurch gekennzeichnet, dass** es den Schritt des Verbindens der Filamente (11) durch quer verlaufende Brücken (17) aus supraleitendem Material umfasst.

## Revendications

1. Bande composite supraconductrice(1), comprenant un substrat (2) et une couche (5) composée d'un matériau supraconducteur, ladite couche de matériau supraconducteur (5) comprenant une pluralité de filaments supraconducteurs (11), qui sont sensiblement parallèles les uns aux autres et à un axe longitudinal (A) de la bande et sont espacés les uns des autres ; la bande étant **caractérisée en ce qu'**elle comprend un revêtement (30) constitué d'un matériau de revêtement conducteur, les filaments (11) étant incorporés dans le revêtement (30) ; et **en ce que** chaque filament (11) est délimité par une paire de parois latérales (15) pourvues de barrières résistives (25).

2. Bande selon la revendication 1, **caractérisée en ce que** les barrières résistives (25) sont définies par des portions respectives (26) des parois latérales (25) dans lesquelles le matériau supraconducteur a une structure modifiée par rapport au corps de la couche de matériau supraconducteur (5).

3. Bande selon la revendication 1 ou 2, **caractérisée en ce que** les filaments (11) sont séparés les uns des autres par des rainures (14) formées à travers ladite couche de matériau supraconducteur (5) sur l'épaisseur entière de ladite couche de matériau supraconducteur (5).

4. Bande selon la revendication 3, **caractérisée en ce que** les rainures (14) sont interrompues par des ponts transversaux (17) pour raccordement entre des filaments adjacents (11).

5. Bande selon la revendication 3 ou la revendication 4, **caractérisée en ce que** les rainures (14) s'étendent en profondeur jusqu'au substrat (2).

6. Bande selon l'une quelconque des revendications 3 à 5, **caractérisée en ce qu'**elle comprend au moins une couche tampon (4) interposée entre le substrat (2) et la couche de matériau supraconducteur (5), les rainures (14) s'étendant à travers la couche de matériau supraconducteur (5) et à travers la couche tampon (4) jusqu'au substrat (2).

7. Bande selon l'une quelconque des revendications précédentes, **caractérisée en ce que** le matériau de revêtement est un matériau de métal.

8. Bande selon l'une quelconque des revendications précédentes, **caractérisée en ce que** le revêtement (30) remplit les rainures (14) et revêt les filaments (11).

9. Bande selon l'une quelconque des revendications précédentes, **caractérisée en ce qu'**elle est enroulée sur elle-même autour dudit axe (A) pour former un fil (33) dans lequel lesdits filaments (11) sont sensiblement parallèles audit axe (A).

10. Bande selon l'une quelconque des revendications précédentes, **caractérisée en ce qu'**elle est tordue sur elle-même le long dudit axe (A) pour former un fil de type tresse (33), dans lequel les filaments (11) sont sensiblement enroulés en spirale les uns par rapport aux autres.

11. Bande selon l'une quelconque des revendications précédentes, **caractérisée en ce que** les filaments (11) sont raccordés les uns aux autres par des ponts transversaux (17) constitués d'un matériau supraconducteur.

12. Procédé de fabrication de bandes composites supraconductrices, comprenant une étape consistant à fournir une bande composite supraconductrice (1) comportant une couche de matériau supraconducteur (5) positionnée sur un substrat (2), et une étape consistant à former dans la couche de matériau supraconducteur (5) une pluralité de filaments supraconducteurs (11) délimitée par une paire respective de parois latérales (15), les filaments (15) étant sensiblement parallèles les uns aux autres et à un axe longitudinal (A) de la bande et étant espacés les uns des autres ; le procédé étant **caractérisé en ce qu'**il comprend en outre une étape consistant à fournir les parois latérales (15) des filaments (11) avec des barrières résistives (25), et une étape de revêtement, dans laquelle les filaments (11) sont incorporés dans un matériau de revêtement conducteur qui forme un revêtement (30) de la bande (1).

13. Procédé selon la revendication 12, **caractérisé en ce qu'**il comprend une étape de gravage, dans laquelle une pluralité de rainures (14) est creusée à travers la couche de matériau supraconducteur (5) sur l'épaisseur entière de ladite couche de matériau supraconducteur (5) afin de délimiter les filaments (11) ; lesdites barrières résistives (25) étant formées dans ladite étape de gravage, en modifiant la structure du matériau supraconducteur desdites parois latérales (15).

14. Procédé selon la revendication 13, **caractérisé en ce que**, dans l'étape de gravage, les rainures (14) sont creusées en étirements discontinus, de telle sorte que chaque rainure (14) soit interrompue par des ponts transversaux (17) raccordant des filaments adjacents.

15. Procédé selon la revendication 13 ou la revendication 14, **caractérisé en ce que**, dans l'étape de gravage, la bande (1) est creusée jusqu'au substrat (2).

16. Procédé selon l'une quelconque des revendications 13 à 15, **caractérisé en ce que** la bande (1) comprend au moins une couche tampon (4) placée entre le substrat (2) et la couche de matériau supraconducteur (5), et l'étape de gravage est réalisée à travers la couche de matériau supraconducteur (5) et à travers la couche tampon (4) jusqu'au substrat (2).

17. Procédé selon l'une quelconque des revendications 12 à 16, **caractérisé en ce que** le matériau de revêtement est un matériau de métal.

18. Procédé selon l'une quelconque des revendications 12 à 17, **caractérisé en ce que**, dans ladite étape de revêtement, le matériau de revêtement remplit lesdites rainures (14) et revêt lesdits filaments (11).

19. Procédé selon l'une quelconque des revendications 12 à 18, **caractérisé en ce qu'**il comprend une étape consistant à enrouler la bande (1) sur elle-même autour dudit axe (A) pour former un fil (33) dans lequel les filaments (11) sont sensiblement parallèles audit axe (A).

20. Procédé selon l'une quelconque des revendications 12 à 19, **caractérisé en ce qu'**il comprend une étape consistant à tordre la bande (1) sur elle-même le long dudit axe (A) pour former un fil de type tresse (33) dans lequel lesdits filaments (11) sont sensiblement enroulés en spirale les uns par rapport aux autres.

21. Procédé selon l'une quelconque des revendications 12 à 20, **caractérisé en ce qu'**il comprend une étape consistant à raccorder les filaments (11) les uns aux autres via des ponts transversaux (17) constitués d'un matériau supraconducteur.
